(19) Europäisches Patentamt
European Patent Office
Office européen des brevets

(11) **EP 2 157 602 A1**

(12) **EUROPEAN PATENT APPLICATION**

(43) Date of publication:
**24.02.2010 Bulletin 2010/08**

(51) Int Cl.:
**H01L 21/762** $^{(2006.01)}$

(21) Application number: **08014803.4**

(22) Date of filing: **20.08.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicant: **Max-Planck-Gesellschaft zur
Förderung der
Wissenschaften e.V.
80539 München (DE)**

(72) Inventors:
• **Moutanabbir, Oussama Dr.
06114 Halle (DE)**
• **Gösele, Ulrich Prof. Dr.
06114 Halle (DE)**

(74) Representative: **Manitz, Finsterwald & Partner
GbR
Postfach 31 02 20
80102 München (DE)**

(54) **A method of manufacturing a plurality of fabrication wafers**

(57)     A method of manufacturing a plurality of fabrication wafers from a donor wafer which includes the steps of, taking the donor wafer and implanting particles in first and second zones spaced from respective first and second surfaces of said donor wafer by respective first and second wafer layers and spaced from each other by a central layer, following this attaching a first handling substrate to said first surface and a second handling substrate to said second surface and finally activating the splitting of said donor wafer at said first and second layers to obtain a first fabrication wafer comprising said first layer on said first substrate, a second fabrication wafer comprising said second layer on said second substrate and said central layer which is capable of use as a further donor wafer or as a fabrication wafer. The production of an intermediate fabrication wafer manufactured by the steps described above and the production of a fabrication wafer made in accordance with the invention are also claimed.

**FIG. 2**

EP 2 157 602 A1

**Description**

The present invention relates to a method of manufacturing a plurality of fabrication wafers from a donor wafer. GaN and related materials hold promise for use in future solid-state lighting, advanced optoelectronics and even high power radio-frequency electronics. However, the potential of these devices is limited by the quality of the fabrication materials that can be grown. Presently, GaN as used in device fabrication is epitaxially grown on foreign substrates (e.g., sapphire) despite their poor lattice and thermal match to GaN. High quality GaN bulk substrates can be produced by hydride vapour phase epitaxy growth of thick GaN layers on sapphire and subsequent separation from the sapphire substrate. The current cost of these free-standing (fs-)GaN wafers is still so high that the concept of transfer of many layers from one fs-GaN wafer to appropriate host substrates by ion cut is not only cost-effective but also technologically highly attractive. This approach to transfer bulk quality thin layers onto any host or handling wafer without any epitaxial relationship required between the layer and the substrate consists of direct wafer bonding of a donor wafer to a handling wafer and the use of an ion cut to cleave a layer of the donor wafer to a handling wafer.

The ion cut can be made, for example, by hydrogen ion implantation as disclosed in U.S. Pat. No. 5,374,564. In fact a whole series of elements, such as boron, carbon, phosphorous, nitrogen, arsenic, fluorine, gallium, thallium, and aluminium can be implanted, using the hydrogen ion implantation and splitting technique as disclosed in U.S. Pat. No. 6,150,239. Also, helium ion implantation alone or in combination with hydrogen can be used in ion-cut process. Hydrogen and/or helium plasma treatments can also be used.

Thin layers of semiconductor wafers can be provided by various methods such as precision grinding and polishing or etching of a thick wafer down to an etch-stop layer introduced by epitaxial methods. However, these processes cannot be used in the case of exceedingly expensive materials such as fs-GaN.

In general, stress induced during one of the layer transfer steps can cause wafer bowing which limits and even prohibits bonding. The stress can originate from the radiation damage introduced by ion implantation, thermal annealing, or both. Thermally induced interfacial stress can lead to the break up of a pair of bonded wafers in the case thermally mismatched materials (i.e., the bonded wafers have different thermal expansion coefficients). Furthermore the use of a hydrogen ion implantation technique to produce thin semiconductor wafers can result in an undesirable increase of the wafer bow which prohibits contacting the donor and the handling wafers. Consequently to achieve high quality bonding and successful layer transfer these problems had to be solved. Regarding the implantation-induced bow enhancement, in the U.S. patent application with the publication numberUS 2007/0175384 A1 a technique for maintaining and even reducing the bow is disclosed. This involves implanting a second splitting zone to the starting wafer, to counteract the stress induced by the introduction of the first splitting zone. Unfortunately, the method presented in US 2007/0175384 A1, leads to significant defects in the remainder of the donor wafer and at the free surface of the starting wafer, rendering the further use of the starting wafer to transfer a second layer almost impossible. In addition, the thermally-induced stress cannot be solved by this method.

The object underlying this invention is to provide a cost-effective and efficient method of manufacturing a plurality of semiconductor wafers from a donor wafer, giving rise to the possibility of not only reducing the initial bow of the starting wafer, but also increasing the bonding capability of the starting wafer, limiting the thermally-induced interfacial stress, and enabling further use of the remainder of the donor wafer.

In order to satisfy the above object, there is provided, in accordance with the present invention, a method of manufacturing a plurality of fabrication wafers from a donor wafer including the steps of:

   a) taking the donor wafer and implanting particles in first and second zones spaced from respective first and second surfaces of said donor wafer by respective first and second wafer layers and spaced from each other by a central layer,

   b) attaching a first handling substrate to said first surface and a second handling substrate to said second surface,

   c) activate splitting of said donor wafer at said first and second layers to obtain a first fabrication wafer comprising said first layer on said first substrate, a second fabrication wafer comprising said second layer on said second substrate and said central layer which is capable of use as a further donor wafer or as a fabrication wafer or as a growth wafer.

The present invention builds on the recognition that bonding of a donor wafer to a handling wafer can be improved by implanting particles in first and second zones of the donor wafer in such a way that the donor wafer has a relatively minimal degree of bowing at the time of bonding to the handling wafer. Furthermore, by simultaneously bonding the donor wafer after implantation to first and second handling substrates and then applying heat to separate the donor wafer at the implanted zones it is possible to avoid severe surface damage to the donor wafer at both the first and second surfaces thereof and to minimize the occurrence of defects in the body of the donor wafer.

In addition, in the case of wafers with a large difference in thermal expansion coefficients, the presence of a second bonded interface counteracts the buildup of annealing-induced interfacial stress at the first interface. This will improve the quality and stability of the bonding. Furthermore, for each thermally induced splitting of the donor wafer, one obtains two fabrication wafers, each mounted on a representative substrate and of good quality as well as a further donor wafer having first and second generally opposite sides of good quality and generally free of defects in the body of the further donor wafer which can be used again, by repeating the method to produce two further fabrication wafers. This significantly improves the economy of the process.

The donor wafer is usually a semiconductor material where the donor wafer is typically a monocrystalline substrate, but can also be a textured monocrystalline substrate or a polycrystalline substrate. The semiconductor material is selected from the group consisting of GaN, AlN, AlGaN, InP, GaAs, InGaAs, as well as other III-V compound semiconductors and their alloys or also other semiconductors such as ZnO or also elemental semiconductors such as germanium or diamond. The donor wafer can also be a multilayer or heterostructure made of more than one semiconductor. In addition the donor wafer can also be selected for optical or ferroelectric properties such as lithium niobate or PZT.

The particles implanted in the donor wafer are either ions, atoms or molecules, and the type of ions used are selected from the group of elements consisting of, hydrogen, boron, carbon, phosphorous, nitrogen, arsenic, fluorine, gallium, thallium, aluminium and helium. The implantation can be performed by ion implantation using monoenergetic ion beams or by plasma immersion ion implantation.

The handling substrates used are selected from a group consisting of conductive substrates, semiconductor substrates, and insulating substrates. The handling substrates are attached to the first and the second surface of the donor wafer using bonding techniques. In the bonded layers, resulting at the interface between each handling substrate and the donor wafer the bonding takes place either directly using direct bonds such as atomic bridges or indirectly by using a bonding layer such as bonding adhesives selected from the group consisting of a glue, a dielectric layer, a metallic oxide layer and a covalent bonding layer.

Furthermore, the resultant central wafer can be recycled as a donor wafer or if it is sufficiently thin as a further fabrication wafer. The invention also relates to the products specified in claims 11 and 12.

The above objects and features of the present invention will become more apparent from the accompanied description of preferred embodiments given, by way of example only with reference to the attached drawings in which:

Figs. 1A to 1C      are schematic sectional illustrations of the first step of the method of the invention.

Fig. 2      is a schematic sectional illustration of the second step of the method and of the invention.

Figs. 3A & 3B      are schematic sectional illustrations of the third step of the method of the invention.

Figs 4A to 4C      are schematic sectional illustrations of the first step of a modified variant of the method of the invention using a bonding layer.

Fig. 5      is a schematic sectional illustration of the second step of the method of the modified variant of the invention using a bonding layer.

Figs. 6A & 6B      are schematic sectional illustrations of the third step of the method of the modified variant of the invention using a bonding layer,

Figs. 7A - 7D      bow measurements of three different (A, B, C) two inch fs-GaN wafers, in accordance with the invention.

Figs. 8A to 8D      are schematic sectional illustration of the bowing of thermally mismatched bonded wafers during the activation of the splitting process.

Fig. 9      is a schematic sectional illustration of the first step of the further variant of the invention.

Fig. 10      is a schematic sectional illustration of the second step of the method of the further variant of the invention for thermally-mismatched layers.

Figs. 11A & 11B      are schematic sectional illustrations of the third step of the method of the further variant of the invention for thermally-mismatched layers.

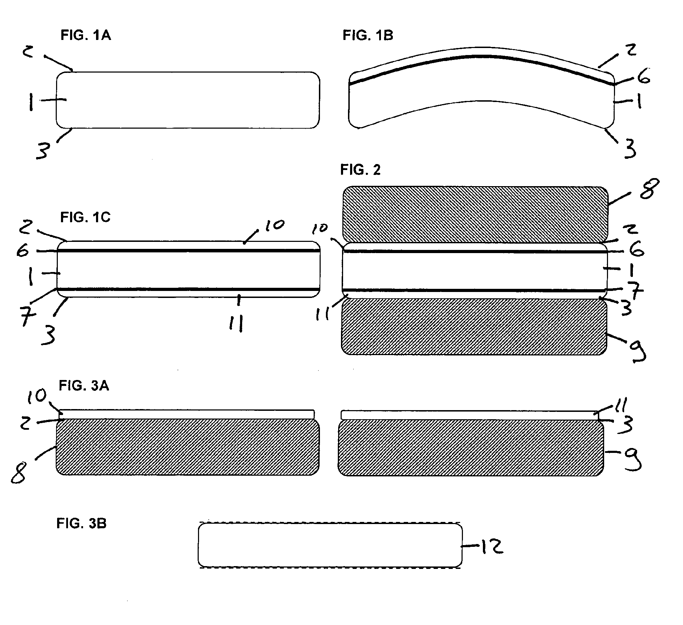

Referring first to Figs. 1A to 1C, 2 and 3A and 3B, a method of manufacturing a plurality of fabrication wafers 10, 11, 12 from a donor wafer 1 includes the following basic steps:

First of all a donor wafer 1 having first and second surface 2, 3 (Fig. 1A) is taken and particles are implanted in first and second zones 6, 7 which are spaced from the respective first and second surfaces 2, 3 of said donor wafer 1 by respective first and second wafer layers 10, 11 and are spaced from each other by a central layer 12 as shown in Figs. 1B and 1C. The implantation can be done using the methods described in US-A-6,150,239 and is preferably done using hydrogen ions especially under the optimal conditions described there or alternatively also by helium ions or a combination of hydrogen and helium ions or plasma treatments.

Following this a first handling substrate 8 is attached to the first surface 2 and a second handling substrate 9 is attached to the second surface 3. This can be done using a direct bonding technique utilizing atomic bridges, e.g. as described in DE-A-10048374. Fig. 2 shows the situation after completion of the bonding step.

As a third step splitting of the donor wafer 1 is activated at said first and second layers 10, 11 to obtain a first fabrication wafer comprising said first layer 10 on said first substrate 8, a second fabrication wafer comprising said second layer 11 on said second substrate 9 and said central layer 12 which is capable of use as a further donor wafer or as a fabrication wafer. The activation of the splitting is done thermally e.g. using the technique described in US-A-6,150,239. The splitting of the thin layer off the donor wafer is initiated by thermal annealing after the high-dose hydrogen implantation, thereby inducing agglomeration of hydrogen in overpressurized bubbles or platelets transforming into microcracks. The thickness of the transferred layer is determined by the hydrogen ion energy. High quality heterostructures frequently unattainable by direct heteroepitaxy could thus be achieved by ion-cutting

Thus Fig. 1A) shows a schematic representation of a donor wafer 1 with polished surfaces 2, 3 prior to the implantation of the splitting zones 6, 7. The donor wafers are typically composed of III-V compound semiconductor wafers, in particular GaN type wafers. However, the donor wafers can consist of any type of monocrystalline, textured monocrystalline or polycrystalline semiconducting material available. Furthermore, the donor wafers could also consist of either monocrystalline, textured monocystalline or polycrystalline metals or monocrystalline, textured monocrystalline or polycrystalline insulating materials such as diamond. If GaN wafers are used then they are typically 300 $\mu$m thick two inch donor wafers, but can have any thickness or size and shape. The surfaces of these GaN wafers are usually polished using chemo mechanical polishing techniques, prior to the application of the splitting zones 6, 7 and the bonding of the handling wafers 8, 9 to the surfaces 2, 3 of the donor wafer 1.

Fig 1B) shows the bow induced following the introduction of the particles for the first splitting zone 6. This bow is found to range typically between 40 and 60 $\mu$m, for a two inch wafer, making any direct bonding of these hydrogen implanted wafers practically impossible. Bonding under pressure or load was found to be ineffective and leads to the breakage of the wafers.

Fig. 1C) shows the reduction of the bow of the donor wafer 1 after the implantation of the second splitting zone 7. This further splitting zone is obtained by the same technique used to apply the first splitting zone 6, and counteracts the stresses in the wafer introduced by the implantation of the splitting zone 6 and the eventual thermal stress during splitting activation.

Fig. 2 shows the result of simultaneous double sided bonding of the handling wafers 8, 9 to the surfaces 2, 3 of the donor wafer 1 following the implantation of the splitting zones 6, 7. In this, the handling wafers 8, 9, which consist either of a conducting substrate, or of a semiconducting substrate or of an insulating substrate such as sapphire, are bonded to the surfaces 2, 3.

Fig. 3 A) shows the resultant fabrication wafers 10, 11 following the simultaneous transfer of the two fabrication wafers 10, 11 from the donor wafer 1. The thickness of the fabrication wafers 10, 11 is dependent on the particle energies used for the implantation of the splitting zones 6, 7.

Fig.3B) shows the fabrication wafer 12 resulting after the splitting of the two fabrication wafers 10, 11 from the donor wafer 1.

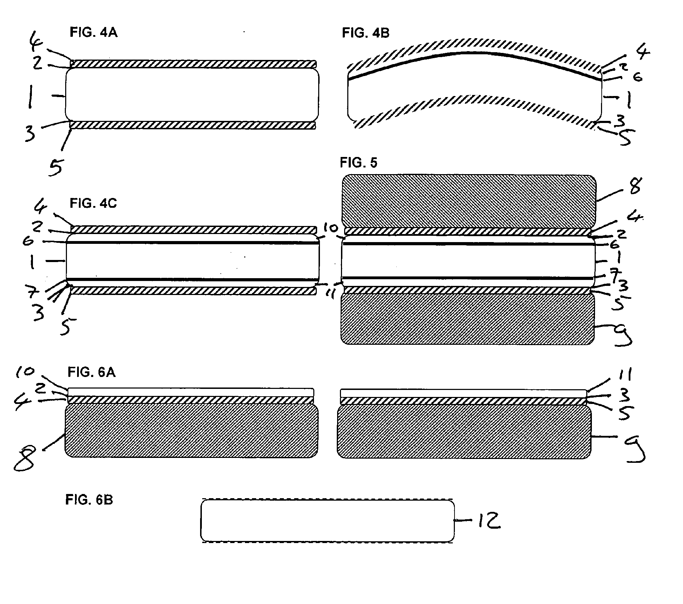

Figs. 4A to 4C and Figs 5 and 6A, essentially show the same schematic diagrams as introduced in Figs 1A) to 1C) and Figs 2 and 3A), only with the addition of the bonding layers 4, 5. In these figures the same reference numerals are used as in Figs. 1A to 1C, 2 and 3A and 3B and the description given for the items identified by these numerals will be understood to apply equally to Figs. 4A to 4C, 5 and 6A and 6B unless something is stated to the contrary. The bonding between the handling wafers 8, 9 to the surfaces 2, 3 is usually achieved using direct bonding, but can also be performed by the use of a bonding layer 4, 5, e.g. by using adhesives such as a glue, a dielectric layer, a metallic oxide, covalent bonds or atomic bridges.

Fig.6B) shows the fabrication wafer 12 resulting after the splitting of the two fabrication wafers 10, 11 from the donor wafer 1.

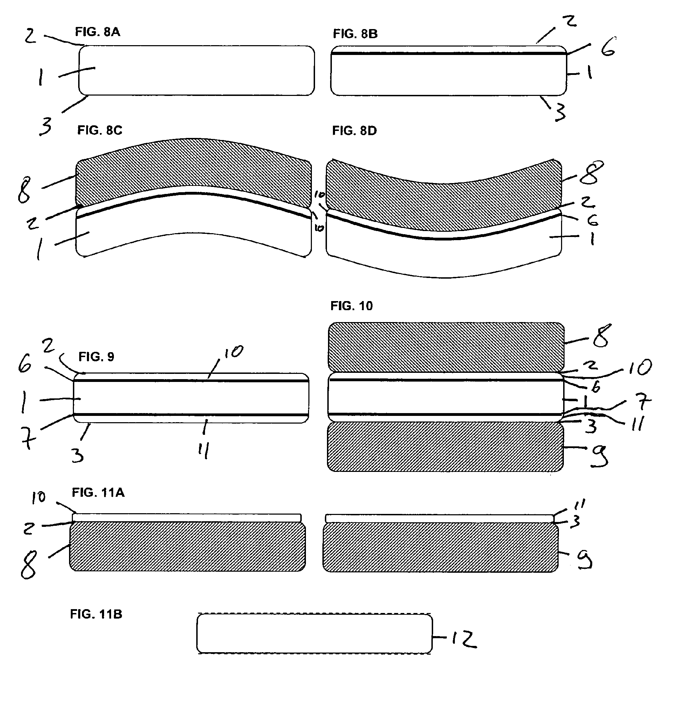

Figs. 8A to 8D illustrate another type of wafer bowing faced during the activation of the splitting process when thermally mismatched wafers are bonded (even when the implantation does not induce any bow enhancement). In Figures 8 to 11 the same reference numerals are used as in Figs. 1 to 6 and the description given for the items identified by these numerals will be understood to apply equally to Figs. 8A to 8C, 9, 10 and 11A and 11 B unless something is stated to the contrary.

Due to the difference in their thermal expansion coefficients, the heating leads to the generation of stress at the interface which induces a distortion of the bonded pair. Fig. 8C (Fig. 8D) shows the bowing in the case of a handling wafer with larger (smaller) thermal expansion coefficient compared to the donor wafer. The bowing during the activation of the splitting leads to debonding and breakage of the bonded pairs. By bonding the donor wafer to a second handling wafer (Fig. 10), the interfacial stress in the second interface counteracts the one induced at the first interface leading to a higher thermal stability of the bonding. In addition, two layers can be simultaneously transferred (Fig. 11).

The resultant fabrication wafer 12 can be further processed as a further donor wafer, or as a fabrication wafer depending on the desired application of the fabrication wafer 12.

Furthermore, the use of two handling wafers will make the bonded wafers less vulnerable to thermal stress induced bowing and de-bonding during the splitting process, making the entire process more efficient and cost-effective. It also helps prevent defects introduced at the surface of the wafer propagating into the body of the wafer. In addition, this double splitting technique is also applicable to cases where the problems of stress or bow are not faced.

-300 $\mu$m-thick 2-inch double side polished fs-GaN wafers were used in this study. Some wafers were subject to room temperature hydrogen ion implantation under the optimal conditions of ion-cutting at the energy of 50 keV with a flux of $2.6 \times 10^{17}$ atom/cm$^2$. During ion implantation, the wafers were tilted by ~7° relative to the incident ion beam to minimize ion channeling. Elastic recoil detection analysis shows that the H implantation depth is ~450 nm with a concentration peak of ~ 13% around 320 nm under the selected implantation conditions. The bow of the wafers was measured using a long range DEKTAK 8 stylus profilometer on a length of 4.5 cm with a horizontal resolution of 3 $\mu$m. Microstructural information about H-ion implantation induced damage was obtained using cross-sectional transmission electron microscopy (XTEM). The XTEM 4 measurements were carried out using a Philips CM 20T machine operated at 200 kV. In order to assess the lattice disorder in the implanted wafers, high-resolution x-ray diffraction measurements were carried out using a XRD, Philips X'Pert MRD system with Cu $K\alpha$ radiation.

For bonding experiments, a 100 nm-thick SiO$_2$ layer was deposited on fs-GaN by plasma-enhanced chemical vapor deposition (PECVD). To prevent undesired out-gassing from the PECVD oxide layer during subsequent heat treatments of the bonded wafer pairs, the fs-GaN wafers were annealed at 850 °C in N$_2$ atmosphere after SiO$_2$-layer deposition. Oxide-deposited wafers were subsequently mirror-polished using chemome-chanical polishing (CMP). The surface roughness was in the order of 0.2 nm over an area of $10 \times 10$ $\mu$m$^2$ after CMP, ensuring the short range flatness required for direct bonding. The polished fs-GaN wafers with SiO$_2$-layer and sapphire wafers (handling wafers) received a 15 min piranha (H$_2$O$_2$:H$_2$SO$_4$ = 1:3) solution cleaning followed by a de-ionized water rinse and N$_2$ gun dry. After these cleaning steps the surfaces were terminated with hydroxyl (OH-) groups necessary to initiate the bonding.

During the implantation of energetic H ions several physical and chemical processes take place leading to a variety of radiation damage-related structures including interstitials, vacancies, hydrogen-point defect complexes, voids, and free hydrogen. XTEM images of as-implanted fs-GaN wafers show a broad damage band extending over a 450 nm-thick layer below the surface. High-dose H-implantation does not lead to the formation of extended defects or platelets as it is the case for other semiconductors. However, it is worth noting that high magnification XTEM studies have evidenced the presence of spherical nanostructures decorating the damaged band. These tiny structures are tentatively attributed to nano-voids. However, to decipher the mechanistic picture of H-induced GaN splitting the exact defect complexes involved need to be thoroughly identified.

X-ray diffraction data of fs-GaN before and after H implantation allow the conclusion that H implantation results in the formation of an inplane biaxial compressive strain, which is detectable as a shoulder extending from the left side of the (0002) GaN diffraction peak. This radiation damage-induced in-plane compressive-strained layer has undesirable consequences on direct bonding of H-implanted fs-GaN wafers.

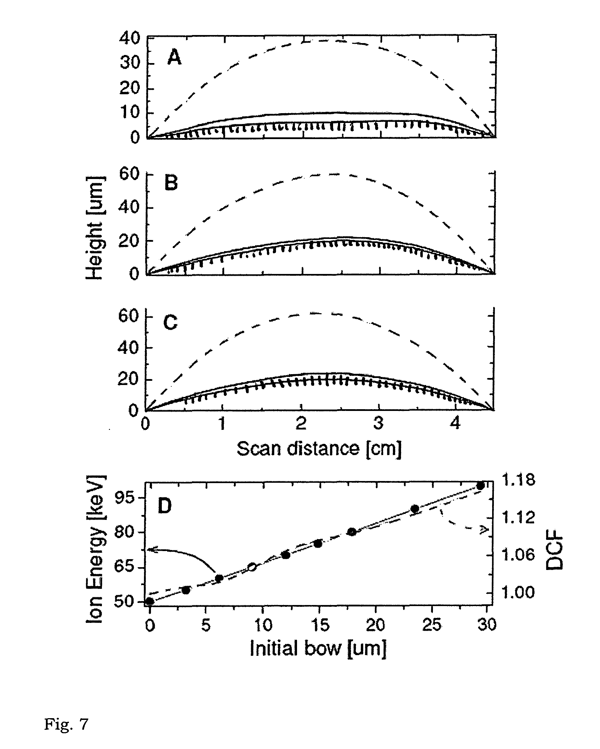

Figures 7A-7C display the profilometer measurements at the N face of the GaN wafers for three different 2-inch fs-GaN wafers labeled A, B, and C. We note that all three wafers are dome-shaped with an initial bow (solid lines) in the order of 9.9, 21.8, and 23.75 $\mu$m for wafers A, B, and C, respectively.

A spectacular increase in the bow is recorded after H-implantation under ion-cut conditions [Fig. 7A-7C, dotted lines]. The tests showed that post-implantation bow reaches 38.9, 59.7, and 62 $\mu$m for wafers A, B, and C, respectively. This strong enhancement is a result of the in-plane compressive strain induced by high dose H-implantation as evidenced by x-ray analysis. The average stress in the damaged layer can be approximately estimated from bow measurements. By analogy to a heteroepitaxial compressively strained layer, the average stress in the damaged layer can be estimated using the modified Stoney's formula:

$$\sigma = \frac{\left(\dfrac{E}{1-\nu}\right)\Delta b t_s^2}{3L^2 t_f} \qquad\qquad 1$$

where E is Young's modulus of GaN, $\nu$ is Poisson's ratio, $\Delta b$ is the variation of the wafer bow induced by H-implantation, L is half of the profilometer scan length, $t_s$ and $t_f$ represent the thicknesses of the substrate and the damaged layer, respectively. Using the data from Fig. 7A-7C, the average stress in the implanted region was found to be in the order of -1.4 GPa.

The bowing of H-implanted fs-GaN wafers strongly limits or even prohibits direct bonding and, consequently, the application of the ion-cut process to transfer thin layers of high quality fs-GaN to other host materials. For direct bonding the wafers should be as flat as possible. The tolerable bows depend sensitively on the material properties and wafer thickness. Unfortunately, the observed post-implantation bowing is too high to allow any contacting of the wafers to be paired and bonded. Indeed, bonding experiments on as-implanted wafers show that the gap between the two surfaces is too large to even permit van der Waals forces to come into play and to initiate the bonding process. It is also worth mentioning that bonding tests under applied forces (e.g. a load in the bonding machine) have led to a systematic breakage and cracking of the wafers to be bonded and therefore does not present a real alternative option.

The use of an intermediate layer as adhesive to *'glue'* H-implanted fs-GaN to the handling wafer can lead to room temperature bonding. However, this approach is not suitable in cases where the subsequent steps of the process involve thermal treatments at high temperatures, e.g. the splitting at ~700 °C and the heteroepitaxy of device structures on the transferred GaN layers at at least 1050 °C. Thus adhesive layers, which are used must be selected so as to withstand such high temperatures. For technological reasons, the main challenge in fs-GaN layer transfer remains the reduction of the post-implantation bow in order to meet the direct bonding criterion.

As addressed above, the strain at or below the surface strongly influences the wafer bow. Similarly, a compressively strained layer at the back side (the Ga-face) of the H-implanted fs-GaN wafer (implantation on the N-face of the wafer) can enhance the bow from the Ga face of the wafer, naturally, thereby reducing the bow at the N-face of the wafer. The final value of the bow depends directly on the amount of strain induced from the Ga-face at a given H-implantation induced N-face bow. Mechanical polishing, heteroepitaxy, plasma treatment, and radiation damage are processes which can be used to produce a strained layer in the back side of H-implanted wafers. Ion implantation appears to be the most useful since it can be included without any additional setup in the ion-cut process. Ga-face H-implantation under the exact conditions will certainly equibalance the bow enhancement observed after H implantation at the N-face and the final bow on the wafer surface to be bonded can reduced down to its initial value. Consequently, direct bonding of these wafers will sensitively depend on the bow of the original wafers. From data reported in Fig. 7A-7C, it can be seen that unimplanted fs-GaN wafers already exhibit a large bow which cannot be tolerated in the direct bonding. Hence, in this specific case, further decrease of the bow is required in order to meet the bonding conditions. By examining Eq. 1, we note that the bow variation $\Delta b$ scales linearly with the thickness of the damaged layer $t_f$ at a fixed value $\sigma$, and *vise versa*. This means that producing a larger damage band or a higher strain can decrease the bow below its initial value. Since the thickness of the damage band depends on the H-ion energy and strain value varies linearly with the implanted flux the bow can be manipulated by adjusting the implantation energy and/or flux. It is noted that the dose can only be increased in a narrow range because even higher doses may lead to room temperature GaN blistering during implantation, which is not interesting for device fabrication since it does not allow any bonding. It has been found useful to increase slightly the implantation depth while keeping the same ion flux of $2.6 \times 10^{17}$ H/cm$^2$. fs-GaN wafers were implanted from the back side at about 65 nm deeper than the first implantation on the N-face.

Results of profilometer measurements after double side implantations are shown in Fig 7A-7C (hatched lines). Expectedly, all the wafers exhibit a bow slightly smaller than the initial value.

Using double-side implantation direct bonding of H-implanted fs-GaN 2-inch wafers to sapphire wafers has become possible. This achievement presents a critical step towards the heterointegration of high quality GaN thin layers, which will have a major impact in the various GaN based device technologies.

Although back-side implantation is found to be a very effective strategy to achieve direct bonding, one may think that it will present an additional costly process step, which may hardly justify the need for ion-cutting to achieve cost-effective substrates at the industrial level. Fortunately, the approach proposed here can be adapted to make ion cut process even more competitive. In fact, the Ga-face is implanted at the optimal flux, therefore, the bonding of both sides of fs-GaN wafers to two handling wafers will lead to a simultaneous transfer of two thin GaN-layers by ion-cutting.

It is noted that deeper implantation can affect the concentration of H needed, which may have an impact on the splitting processes. Therefore, a more accurate control over the back side implantation dose might be needed in order to match the critical H concentration for layer splitting (about 16%) and simultaneously producing the necessary strain required for the bow reduction. In order to verify a possible impact of deeper implantation, some calculations were performed by combining Eq. 1 and SRIM2006 simulations code. The calculations were carried out for wafers with an initial bow ranging from 0 to 30 $\mu$m. By assuming that the induced strain is only sensitive to the atomic displacements/H ratio, it was found that a wafer with an initial bow as large as 30 $\mu$m can be flattened by back-side implantation at the energy of 100 keV corresponding to an implantation depth of about 565 nm. The dimensionless dose correction factor (DCF) is estimated to be 1.16, which means that back-side implantation should be carried out at a flux of ~3 x $10^{17}$ H/cm$^2$. Since splitting can take place in a range of ion flux, it is probable that the simultaneous double bonding and splitting of fs-GaN can be performed without the need for the adjustments of ion dose and energy, at least on the assumption that the wafers initial bow can be tolerated in direct bonding (i.e. is less than a few microns).

**Claims**

1. A method of manufacturing a plurality of fabrication wafers (10; 11; 12) from a donor wafer (1) including the steps of:

   a) taking the donor wafer (1) and implanting particles in first and second zones (6; 7) spaced from respective first and second surfaces (2; 3) of said donor wafer (1) by respective first and second wafer layers (10; 11) and spaced from each other by a central layer (12),
   b) attaching a first handling substrate (8) to said first surface (2) and a second handling substrate (9) to said second surface (3),
   c) activating splitting of said donor wafer (1) at said first and second layers (10; 11) to obtain a first fabrication wafer comprising said first layer (10) on said first substrate (8), a second fabrication wafer comprising said second layer (11) on said second substrate (9) and said central layer (12) which is capable of use as a further donor wafer or as a fabrication wafer.

2. A method in accordance with claim 1, wherein a wafer consisting of a semiconductor material is selected as said donor wafer.

3. A method in accordance with claim 2, wherein said semiconductor is a monocrystalline substrate.

4. A method in accordance with claim 2, wherein said semiconductor is a textured moncrystalline substrate or a polycrystalline substrate.

5. A method in accordance with any one of claims 2 to 4, wherein said wafer is selected from the group consisting of GaN, AlN, AlGaN, InP, GaAs, InGaAs as well as other III-V compound semiconductors or also other semiconductors such as ZnO or also elemental semiconductors such as germanium or diamond.

6. A method in accordance with any one of claims 2 to 5, wherein said wafer is a multilayerstructure or heterostructure of more than one semiconductor selected from the group consisting of GaN, AlN, AlGaN, InP, GaAs, InGaAs as well as other III-V compound semiconductors or also other semiconductors such as ZnO or also elemental semiconductors such as germanium or diamond.

7. A method in accordance with any one of claims 1 to 5, wherein the implanted particles are selected from the group of ions, atoms, and molecules.

8. A method in accordance with claim 6, wherein said implanted particles consist of at least one of ions, atoms and molecules selected from the group of elements consisting of, hydrogen, boron, carbon, phosphorous, nitrogen, arsenic, fluorine, gallium, thallium, aluminium and helium

9. A method in accordance with any one of the preceding claims, wherein said first and second handling substrates (8; 9) are selected from a group consisting of conductive substrates, semiconductor substrates, and insulating substrates including ferroelectric substrates such as lithium niobate or PZT.

10. A method in accordance with any one of the preceding claims, wherein the step of attaching either of said first and second handling substrates to either of said first and second surfaces of said donor wafer is performed by using a bonding layer (4; 5).

11. A method in accordance with claim 9, wherein said bonding layer (4; 5) is selected from the group consisting of a glue, a dielectric layer, a metallic oxide layer, a covalent bonding layer, atomic bridges and a direct bond.

12. A method to suppress or reduce the interfacial stress induced by heating.

13. An intermediate fabrication wafer (12) made by the steps a.) and b.) of any one of the preceding claims.

14. A fabrication wafer (12) made in accordance with any one of the preceding claims 1 to 10.

FIG. 1A

FIG. 1B

FIG. 1C

FIG. 2

FIG. 3A

FIG. 3B

FIG. 4A

FIG. 4B

FIG. 4C

FIG. 5

FIG. 6A

FIG. 6B

Fig. 7

**FIG. 8A**

**FIG. 8B**

**FIG. 8C**

**FIG. 8D**

**FIG. 9**

**FIG. 10**

**FIG. 11A**

**FIG. 11B**

Europäisches
Patentamt

European
Patent Office

Office européen
des brevets

## EUROPEAN SEARCH REPORT

Application Number

EP 08 01 4803

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 767 486 A (CANON KK [JP]) 9 April 1997 (1997-04-09) * abstract; claims; figures 5C-5F * * column 25, line 27 - column 27, line 5 * * column 10, line 36 - line 38 * | 1-3,7-14 | INV. H01L21/762 |
| Y | | 4-6 | |
| X | WO 02/47136 A (MOTOROLA INC [US]; STANLEY PETER [DE]; STANLEY TIMOTHY [US] MOTOROLA I) 13 June 2002 (2002-06-13) * abstract; claims; figure 2 * | 1-3,7-14 | |
| X | WO 03/017358 A (ROSEMOUNT AEROSPACE INC [US]) 27 February 2003 (2003-02-27) * abstract; claims; figures 2D-2E * | 1-3,7-14 | |
| X | US 2001/019877 A1 (MIYAKE KOJI [JP] ET AL) 6 September 2001 (2001-09-06) * abstract; claims; figures 2G,2H * | 1-3,7-14 | |
| X | WO 00/63965 A (SILICON GENESIS CORP [US]; KANG SIEN G [US]; MALIK IGOR J [US]) 26 October 2000 (2000-10-26) * abstract; claims; figure 19C * | 1-3,7-14 | TECHNICAL FIELDS SEARCHED (IPC) H01L |
| Y | US 2008/132031 A1 (AULNETTE CECILE [FR] ET AL AULNETTE CECILE [FR] ET AL) 5 June 2008 (2008-06-05) * claims; figures 1-3 * | 4-6 | |
| Y | US 2007/054466 A1 (HEBRAS XAVIER [FR]) 8 March 2007 (2007-03-08) * abstract; claims; figures 1,2 * | 4-6 | |
| A | US 2006/286770 A1 (GHYSELEN BRUNO [FR] ET AL) 21 December 2006 (2006-12-21) * abstract; claims; figures * | 1-14 | |

The present search report has been drawn up for all claims

| Place of search | Date of completion of the search | Examiner |
|---|---|---|
| The Hague | 27 January 2009 | Wirner, Christoph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 01 4803

This annex lists the patent family members relating to the patent documents cited in the above-mentioned European search report.
The members are as contained in the European Patent Office EDP file on
The European Patent Office is in no way liable for these particulars which are merely given for the purpose of information.

27-01-2009

| Patent document cited in search report | | Publication date | Patent family member(s) | | Publication date |
|---|---|---|---|---|---|
| EP 0767486 | A | 09-04-1997 | CA | 2187269 A1 | 07-04-1997 |
| | | | CN | 1159071 A | 10-09-1997 |
| | | | DE | 69631233 D1 | 05-02-2004 |
| | | | DE | 69631233 T2 | 11-11-2004 |
| | | | JP | 3352340 B2 | 03-12-2002 |
| | | | JP | 9162090 A | 20-06-1997 |
| | | | SG | 63669 A1 | 30-03-1999 |
| | | | US | 5854123 A | 29-12-1998 |
| WO 0247136 | A | 13-06-2002 | AU | 3575402 A | 18-06-2002 |
| | | | US | 2002068418 A1 | 06-06-2002 |
| WO 03017358 | A | 27-02-2003 | EP | 1417705 A1 | 12-05-2004 |
| | | | US | 2003040136 A1 | 27-02-2003 |
| | | | US | 2003036247 A1 | 20-02-2003 |
| US 2001019877 | A1 | 06-09-2001 | FR | 2804245 A1 | 27-07-2001 |
| | | | JP | 2001203340 A | 27-07-2001 |
| | | | TW | 567254 B | 21-12-2003 |
| WO 0063965 | A | 26-10-2000 | AU | 4481100 A | 02-11-2000 |
| US 2008132031 | A1 | 05-06-2008 | CN | 101192512 A | 04-06-2008 |
| | | | EP | 1928020 A1 | 04-06-2008 |
| | | | JP | 2008141206 A | 19-06-2008 |
| | | | KR | 20080049630 A | 04-06-2008 |
| | | | SG | 143126 A1 | 27-06-2008 |
| US 2007054466 | A1 | 08-03-2007 | CN | 101258591 A | 03-09-2008 |
| | | | EP | 1922751 A1 | 21-05-2008 |
| | | | WO | 2007028800 A1 | 15-03-2007 |
| | | | FR | 2890489 A1 | 09-03-2007 |
| | | | KR | 20080040759 A | 08-05-2008 |
| US 2006286770 | A1 | 21-12-2006 | CN | 1781188 A | 31-05-2006 |
| | | | EP | 1631983 A1 | 08-03-2006 |
| | | | FR | 2855909 A1 | 10-12-2004 |
| | | | WO | 2005004232 A1 | 13-01-2005 |
| | | | JP | 2006527478 T | 30-11-2006 |
| | | | KR | 20060017615 A | 24-02-2006 |
| | | | US | 2004248378 A1 | 09-12-2004 |

For more details about this annex : see Official Journal of the European Patent Office, No. 12/82

**EP 2 157 602 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5374564 A
- US 6150239 A
- US 20070175384 A1
- DE 10048374 A